# DEMANDE DE BREVET EUROPEEN

(11) **EP 4 167 282 A1**
(43) Date de publication de la demande: **19.04.2023**
(21) Numéro de dépôt: 22200317.0
(22) Date de dépôt: 07.10.2022
(51) Int. Cl.: H01L 25/075

(54) **PROCÉDÉ DE FABRICATION D'UN DISPOSITIF OPTOÉLECTRONIQUE**

(30) Priorité: 15.10.2021 FR 2110976
(71) Demandeur: Commissariat à l'énergie atomique et aux énergies alternatives, 75015 Paris (FR)
(72) Inventeur: TEMPLIER, François, 38054 GRENOBLE CEDEX 09 (FR); LEVY, François, 38054 GRENOBLE CEDEX 09 (FR)
(74) Mandataire: Cabinet Beaumont

(57) **Abrégé**

La présente description concerne un procédé de fabrication d'un dispositif optoélectronique comprenant les étapes successives suivantes :
a) former, sur un circuit intégré de contrôle (151) préalablement formé dans et sur un substrat semiconducteur, une pluralité de diodes électroluminescentes inorganiques (L) comportant des éléments semiconducteurs tridimensionnels ; et
b) déposer une couche active semiconductrice photosensible (161) de sorte à combler des espaces libres s'étendant latéralement entre les diodes électroluminescentes inorganiques.

## Description

### Domaine technique

La présente description concerne de façon générale le domaine des dispositifs optoélectroniques, et vise plus particulièrement un procédé de fabrication d'un dispositif optoélectronique combinant une fonction d'émission lumineuse et une fonction de capture optique.

### Technique antérieure

Diverses applications sont susceptibles de tirer profit d'un dispositif optoélectronique combinant une fonction d'émission lumineuse et une fonction de capture optique. Un tel dispositif peut par exemple être utilisé pour réaliser un écran d'affichage interactif.

### Résumé de l'invention

Un objet d'un mode de réalisation est de pallier tout ou partie des inconvénients des solutions connues pour réaliser un dispositif optoélectronique combinant une fonction d'émission lumineuse et une fonction de capture optique.

Pour cela, un mode de réalisation prévoit un procédé de fabrication d'un dispositif optoélectronique comprenant les étapes successives suivantes :
a) former, sur un circuit intégré de contrôle préalablement formé dans et sur un substrat semiconducteur, une pluralité de diodes électroluminescentes inorganiques comportant des éléments semiconducteurs tridimensionnels ; et
b) déposer une couche active semiconductrice photosensible de sorte à combler des espaces libres s'étendant latéralement entre les diodes électroluminescentes inorganiques.

Selon un mode de réalisation, chaque élément semiconducteur tridimensionnel présente des dimensions nanométriques ou micrométriques.

Selon un mode de réalisation, chaque élément semiconducteur tridimensionnel présente une forme pyramidale.

Selon un mode de réalisation, chaque élément semiconducteur tridimensionnel présente une forme filaire.

Selon un mode de réalisation, le procédé comprend la formation d'une pluralité de diodes photosensibles dans la couche active semiconductrice photosensible.

Selon un mode de réalisation, le procédé comprend, avant l'étape a), une étape d'élimination des diodes électroluminescentes inorganiques situées à des emplacements souhaités des diodes photosensibles.

Selon un mode de réalisation, le procédé comprend, après l'étape a) et avant l'étape b), une étape de formation d'ouvertures s'étendant latéralement entre les diodes électroluminescentes inorganiques.

Selon un mode de réalisation, les ouvertures sont formées par gravure en utilisant les diodes électroluminescentes inorganiques comme masque de gravure.

Selon un mode de réalisation, la couche active semiconductrice photosensible comprend au moins un matériau polymère.

Selon un mode de réalisation, la couche active semiconductrice photosensible comprend des boîtes quantiques.

Selon un mode de réalisation, la couche active semiconductrice photosensible est une couche semiconductrice organique.

Selon un mode de réalisation, la couche active semiconductrice photosensible est déposée par voie liquide entre les diodes électroluminescentes inorganiques.

Selon un mode de réalisation, le procédé comporte, après l'étape b), une étape de fixation d'un substrat de support temporaire du côté d'une face du dispositif opposée au circuit intégré, suivie d'une étape de découpe de l'ensemble comportant le circuit intégré, la couche active semiconductrice photosensible et les diodes électroluminescentes inorganiques en une pluralité de puces élémentaires.

Selon un mode de réalisation, le procédé comporte en outre une étape de transfert et de fixation desdites puces élémentaires sur un substrat de report du dispositif, puis une étape de retrait du substrat de support temporaire.

Un mode de réalisation prévoit un dispositif optoélectronique comportant :
- un circuit intégré de contrôle formé dans et sur un substrat semiconducteur ;
- une pluralité de diodes électroluminescentes inorganiques disposées sur une face du circuit intégré de contrôle et comportant des éléments semiconducteurs tridimensionnels ; et
- une couche active semiconductrice photosensible s'étendant latéralement entre les diodes électroluminescentes inorganiques.

Selon un mode de réalisation, le dispositif optoélectronique comprend un substrat de report et une pluralité de puces élémentaires fixées et connectées électriquement au substrat de report, chaque puce élémentaire comprenant un dispositif tel que décrit, le circuit intégré de contrôle étant disposé du côté du substrat de report.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B, 1C, 1D, 1E, 1F, 1G et 1H sont des vues en coupe illustrant des étapes successives d'un exemple d'un procédé de fabrication d'un dispositif optoélectronique selon un mode de réalisation ;
les figures 2A et 2B sont des vues en coupe illustrant des étapes successives d'une variante du procédé des figures 1A à 1H ;
les figures 3A, 3B et 3C sont des vues en coupe illustrant des étapes successives d'une autre variante du procédé des figures 1A à 1H ; et
les figures 4A, 4B, 4C, 4D, 4E, 4F et 4G sont des vues en coupe illustrant d'autres étapes successives d'un exemple d'un procédé de fabrication d'un dispositif optoélectronique selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des diodes photosensibles, des diodes électroluminescentes (LED) et des circuits intégrés de contrôle des dispositifs décrits n'a pas été détaillée, la réalisation détaillée de ces éléments étant à la portée de la personne du métier à partir des indications de la présente description. Par ailleurs, les diverses applications des dispositifs décrits n'ont pas été détaillées, les modes de réalisation décrits étant compatibles avec toutes ou la plupart des applications susceptibles de tirer profit d'un dispositif combinant une fonction d'émission lumineuse et une fonction de capture optique (photodétection). En outre, les différentes étapes de croissance épitaxiale mises en œuvre pour réaliser les LED élémentaires tridimensionnelles des dispositifs optoélectroniques décrits n'ont pas été détaillées, les modes de réalisation décrits étant compatibles avec les procédés connus de réalisation de telles LED élémentaires tridimensionnelles.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

On désigne par "transmittance d'une couche" le rapport entre l'intensité du rayonnement sortant de la couche et l'intensité du rayonnement entrant dans la couche. Dans la suite de la description, une couche ou un film est dit opaque à un rayonnement lorsque la transmittance du rayonnement au travers de la couche ou du film est inférieure à 10 %. Dans la suite de la description, une couche ou un film est dit transparent à un rayonnement lorsque la transmittance du rayonnement au travers de la couche ou du film est supérieure à 10 %.

Dans la suite de la description, "lumière visible" désigne un rayonnement électromagnétique dont la longueur d'onde est comprise entre 380 nm et 780 nm et "rayonnement infrarouge" désigne un rayonnement électromagnétique dont la longueur d'onde est comprise entre 780 nm et 15 µm. En outre, "rayonnement infrarouge proche" désigne plus particulièrement un rayonnement électromagnétique dont la longueur d'onde est comprise entre 780 nm et 1,7 µm.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Selon un aspect d'un mode de réalisation, un dispositif optoélectronique combinant une fonction d'émission lumineuse et une fonction de photodétection est réalisé par la mise en œuvre d'un procédé comprenant les étapes de former, sur un circuit intégré de contrôle préalablement formé dans et sur un substrat semiconducteur, une pluralité de diodes électroluminescentes ("Light-Emitting Diode" - LED, en anglais) inorganiques comportant des éléments semiconducteurs tridimensionnels, puis de déposer une couche active semiconductrice de sorte à combler des espaces entre les diodes électroluminescentes. Le procédé comprend en outre des étapes permettant de définir une pluralité de diodes photosensibles, ou photodétecteurs, dans la couche active semiconductrice.

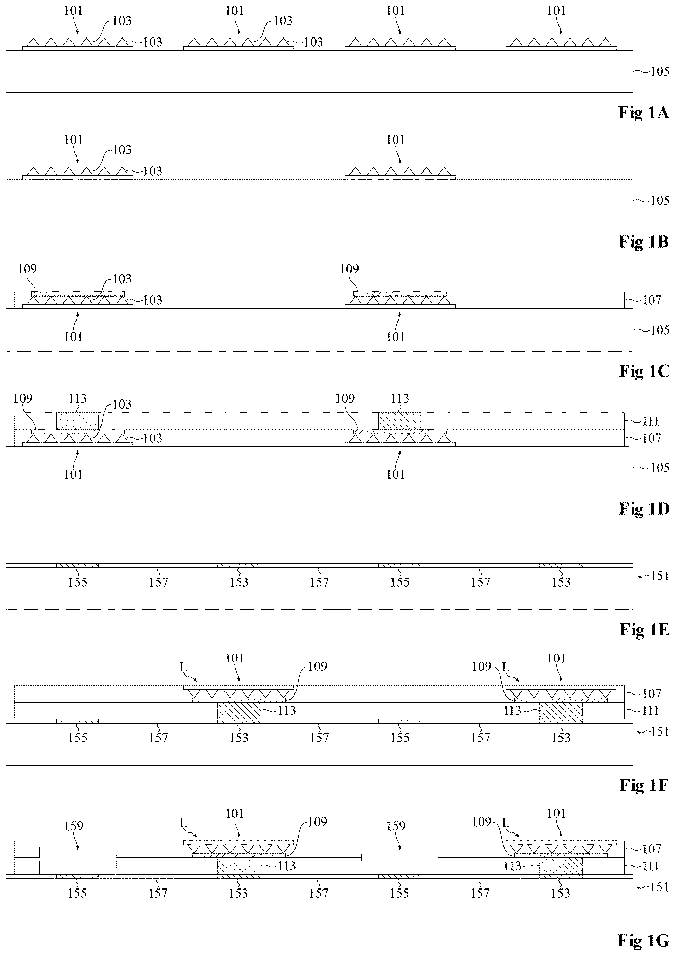

Les figures 1A à 1H sont des vues en coupe illustrant des étapes successives d'un exemple, non limitatif, de mise en œuvre d'un tel procédé. Diverses variantes sont à la portée de la personne du métier à partir des indications de la présente description.

Par souci de simplification, les figures 1A à 1H représentent la réalisation d'un dispositif comportant des pixels comprenant chacun une diode photosensible D et une LED inorganique L. Cet exemple n'est toutefois pas limitatif, le procédé décrit pouvant bien entendu être adapté pour réaliser des dispositifs dont les pixels comprennent chacun des nombres de diodes photosensibles et de LED inorganiques différents de ceux représentés, par exemple une diode photosensible et trois LED inorganiques. À titre d'exemple, pour chaque pixel d'une image couleur à afficher, le dispositif peut comprendre une LED inorganique adaptée à n'émettre que la lumière bleue, par exemple dans la plage de longueurs d'onde de 430 à 490 nm (définissant un premier sous-pixel appelé sous-pixel bleu), une autre LED inorganique adaptée à n'émettre que la lumière verte, par exemple dans la plage de longueurs d'onde de 510 à 570 nm (définissant un deuxième sous-pixel appelé sous-pixel vert) et encore une autre LED inorganique adaptée à n'émettre que la lumière rouge, par exemple dans la plage de longueurs d'onde de 600 à 720 nm (définissant un troisième sous-pixel appelé sous-pixel rouge). En outre, les modes de réalisation décrits s'appliquent à des dispositifs présentant des plages de longueurs d'ondes d'émission et de réception quelconques, par exemple situées chacune dans l'infrarouge et/ou dans le visible.

Les figures 1A à 1F illustrent plus particulièrement des étapes successives de fabrication d'un circuit optoélectronique comportant, pour chaque pixel du dispositif, une cellule d'émission 101 commandable individuellement pour émettre un rayonnement électromagnétique à la longueur d'onde d'émission du pixel. Chaque cellule d'émission 101 comporte une ou plusieurs LED élémentaires connectées en parallèle, comprenant chacune un élément semiconducteur tridimensionnel 103. Chaque LED élémentaire est adaptée à émettre un rayonnement électromagnétique à la longueur d'onde d'émission de la LED inorganique L à laquelle elle appartient. Dans chaque cellule d'émission 101, les LED élémentaires de la cellule présentent sensiblement les mêmes dimensions et sont régulièrement réparties sur la surface de la cellule, aux dispersions de fabrication près.

La figure 1A est une vue en coupe illustrant une structure obtenue à l'issue d'une étape de formation, sur une face supérieure d'un substrat de support 105, des cellules d'émission 101 comprenant les éléments semiconducteurs tridimensionnels 103.

Le substrat 105 peut présenter une structure monobloc, ou peut correspondre à une couche recouvrant un support constitué d'un autre matériau. Le substrat 105 est par exemple en un matériau semiconducteur, par exemple en silicium. À titre d'exemple, le substrat 105 est une plaquette ou un morceau de plaquette en silicium monocristallin, la face supérieure du substrat 105 présentant par exemple une orientation cristalline <111>. Le substrat 105 peut comporter une structure multicouche de type silicium sur isolant, également appelée SOI (de l'anglais "Silicon On Insulator"). À titre de variante, le substrat 105 peut être en saphir.

De manière générale, le substrat 105 peut être en tout type de matériau adapté à la réalisation des éléments semiconducteurs tridimensionnels 103 des cellules d'émission 101. Dans la présente description, l'expression "élément semiconducteur tridimensionnel" désigne un élément de forme allongée selon une direction privilégiée, appelée direction longitudinale. Un tel élément peut présenter une forme filaire, par exemple à section hexagonale, une forme conique, tronconique ou, comme dans l'exemple représenté, une forme pyramidale. Les éléments semiconducteurs tridimensionnels 103 présentent par exemple des dimensions nanométriques ou micrométriques. Les éléments semiconducteurs tridimensionnels 103 peuvent être par exemple désignés par les termes nanofils ou encore nanopyramides. Plus précisément, chaque élément semiconducteur tridimensionnel présente par exemple une dimension transversale maximale comprise entre 5 nm et 2,5 µm, par exemple entre 50 nm et 1 µm, et une dimension longitudinale supérieure ou égale à une fois sa dimension transversale maximale.

Les éléments semiconducteurs tridimensionnels 103 des cellules d'émission 101 sont par exemple réalisés par une technique de croissance localisée. À titre d'exemple, au moins une couche de germination (ou couche de nucléation), par exemple une couche continue ou une couche structurée comprenant des portions de couche disjointes, et au moins une couche destinée à former un masque de croissance sélective, permettant de bloquer localement la croissance des éléments semiconducteurs tridimensionnels 103, par exemple une couche électriquement isolante, sont successivement déposées sur la face supérieure du substrat 105, puis des ouvertures traversantes sont formées dans la couche électriquement isolante de façon à exposer des parties de la couche de germination aux emplacements souhaités des LED élémentaires du dispositif. Les ouvertures présentent par exemple des dimensions latérales sensiblement égales aux dimensions transversales souhaitées des éléments semiconducteurs tridimensionnels 103 des LED élémentaires des pixels. En pratique, les éléments semiconducteurs tridimensionnels 103 peuvent toutefois s'étendre latéralement sur et en contact avec le masque de croissance au voisinage des ouvertures. Les éléments semiconducteurs tridimensionnels 103 sont ensuite obtenus, par croissance épitaxiale depuis la couche de germination, en vis-à-vis des ouvertures préalablement formées. La couche de germination comprend par exemple un ou plusieurs matériaux favorisant la croissance des éléments semiconducteurs tridimensionnels 103 des LED élémentaires du dispositif. À titre de variante, les éléments semiconducteurs tridimensionnels 103 peuvent être réalisés par croissance épitaxiale à partir de germes préalablement formés de façon localisée aux emplacements souhaités des LED élémentaires du dispositif, par exemple par une technique dite vapeur-liquide-solide (VLS).

Les LED élémentaires des cellules d'émission 101 peuvent présenter une structure dite axiale. L'élément semiconducteur tridimensionnel 103 de chaque LED élémentaire comporte alors par exemple, depuis la face supérieure du substrat 105 et le long de la direction longitudinale de l'élément semiconducteur tridimensionnel 103, une région semiconductrice dopée d'un premier type de conductivité, par exemple le type N, une région semiconductrice active et une autre région semiconductrice dopée d'un deuxième type de conductivité, le type P dans cet exemple. À titre de variante, les LED élémentaires des cellules d'émission 101 peuvent présenter une structure dite radiale, par exemple de type cœur-coquille, dans laquelle les régions semiconductrices dopées des premier et deuxième types de conductivité et la région semiconductrice active sont concentriques et disposées radialement le long de la direction transversale des éléments semiconducteurs tridimensionnels 103. Bien que cela n'ait pas été détaillé en figure 1A, les éléments semiconducteurs tridimensionnels 103 de structure axiale ou radiale peuvent en outre comporter une ou plusieurs autres couches, par exemple choisies parmi des couches d'injection, de transport ou de blocage de charges (électrons ou trous).

Dans l'exemple illustré en figure 1A, les éléments semiconducteurs tridimensionnels 103 revêtent partiellement la face supérieure du substrat 105, de sorte que les cellules d'émission 101 sont disjointes. À titre de variante, les éléments semiconducteurs tridimensionnels 103 peuvent revêtir intégralement la face supérieure du substrat 105. Dans ce cas, les éléments semiconducteurs tridimensionnels 103 non désirés, situés entre les futurs pixels du dispositif optoélectronique, sont par exemple éliminés lors d'une étape ultérieure.

Dans cet exemple, les cellules d'émission 101 comprenant les éléments semiconducteurs tridimensionnels 103 sont formées non seulement aux emplacements souhaités des LED inorganiques L, mais également aux emplacements souhaités des diodes photosensibles D.

La figure 1B est une vue en coupe illustrant une structure obtenue à l'issue d'une étape ultérieure d'élimination des cellules d'émission 101 aux emplacements souhaités des diodes photosensibles D. Seules les cellules d'émission 101 situées aux emplacements souhaités des LED inorganiques L sont conservées à l'issue de cette étape. Les cellules d'émission situées aux emplacements souhaités des diodes photosensibles D sont par exemple éliminées par photolithographie puis gravure, par exemple par gravure plasma. On peut déposer, préalablement à la gravure, une couche de protection revêtant la face supérieure des éléments semiconducteurs tridimensionnels 103 à conserver.

À titre de variante, les étapes décrites en relation avec les figures 1A et 1B peuvent être remplacées par une étape de croissance épitaxiale des éléments semiconducteurs tridimensionnels 103 localisée aux emplacements souhaités des LED inorganiques L uniquement, aucune cellule d'émission 101 n'étant alors formée aux emplacements souhaités des diodes photosensibles D à l'issue de la croissance épitaxiale des éléments semiconducteurs tridimensionnels 103.

La figure 1C est une vue en coupe illustrant une structure obtenue à l'issue d'une étape ultérieure de dépôt d'une couche électriquement isolante 107 du côté de la face supérieure du substrat 105 et de formation d'électrodes 109 à l'intérieur de la couche 107.

La couche électriquement isolante 107 est par exemple déposée pleine plaque, et recouvre totalement les cellules d'émission 101 subsistant aux emplacements souhaités des LED inorganiques L à l'issue de l'étape de la figure 1B ainsi que des zones de la face supérieure du substrat 105 non revêtues par les cellules d'émission 101. À titre d'exemple, la couche 107 est en dioxyde de silicium.

Des ouvertures sont ensuite formées dans la couche 107, par exemple à l'aplomb des cellules d'émission 101, de sorte à exposer une partie supérieure, dans l'orientation de la figure 1C, des cellules d'émission 101. Les ouvertures sont ensuite remplies d'un matériau conducteur, par exemple un métal tel que le nickel, le platine, le palladium, l'indium, l'aluminium, l'argent, le titane, etc. ou un alliage métallique, de sorte à former les électrodes 109 sur et en contact avec la face supérieure des cellules d'émission 101. Les électrodes 109 peuvent comporter une seule couche, ou présenter une structure multicouche. Une étape optionnelle de planarisation, par exemple par polissage mécano-chimique, peut être prévue de sorte que, comme dans l'exemple illustré en figure 1C, les électrodes 109 comblent totalement les ouvertures préalablement formées dans la couche 107 et affleurent la face supérieure de la couche 107. Les électrodes 109 constituent par exemple chacune une électrode d'anode commune aux LED élémentaires de la cellule d'émission 101 à laquelle elles appartiennent.

En pratique, plusieurs étapes de gravure sélective de la couche 107 peuvent être mises en œuvre, par exemple dans un cas où le dispositif optoélectronique comporte plusieurs types de cellules d'émission 101 adaptées à émettre de la lumière dans des gammes de longueurs d'ondes distinctes et présentant des hauteurs différentes. Ainsi, une épaisseur plus importante de la couche 107 peut être éliminée au-dessus des cellules d'émission 101 les moins hautes par rapport aux cellules d'émission 101 les plus hautes préalablement à la réalisation des électrodes 109.

À titre de variante, on peut prévoir, postérieurement au dépôt de la couche 107, de planariser cette couche de façon non sélective afin d'exposer la partie supérieure des cellules d'émission 101 préalablement à la réalisation des électrodes 109.

À titre de variante, la couche 107 peut être omise, par exemple dans le cas où les éléments semiconducteurs tridimensionnels 103 sont à structure radiale.

La figure 1D est une vue en coupe illustrant une structure obtenue à l'issue d'une étape ultérieure de dépôt d'une autre couche électriquement isolante 111 du côté de la face supérieure du substrat 105 et de formation de plots conducteurs 113 à l'intérieur de la couche 111.

La couche électriquement isolante 111 est par exemple déposée pleine plaque, et revêt les faces supérieures de la couche électriquement isolante 107 et des électrodes 109. La couche 111 est par exemple en le même matériau que la couche 107, par exemple en dioxyde de silicium. La couche 111 peut en outre être planarisée.

Des ouvertures sont ensuite formées dans la couche 111, par exemple à l'aplomb des cellules d'émission 101, de sorte à exposer, au moins partiellement, la face supérieure des électrodes 109. Les ouvertures sont ensuite remplies d'un matériau conducteur, par exemple un métal tel que le cuivre ou un alliage métallique, de sorte à former les plots 113. Une étape de planarisation, par exemple par polissage mécano-chimique, peut être prévue de sorte que, comme dans l'exemple illustré en figure 1D, les plots conducteurs 113 comblent totalement les ouvertures préalablement formées dans la couche 111 et affleurent la face supérieure de la couche 111. À titre d'exemple, les plots métalliques 113 ainsi que les portions de couche isolante 111 subsistant entre ces plots sont réalisés par un procédé de type "damascène".

La figure 1E est une vue en coupe représentant de façon schématique et partielle un circuit intégré de contrôle 151 formé dans et sur un substrat semiconducteur. À titre d'exemple, le circuit intégré de contrôle 151 est formé dans et sur un substrat massif de silicium. À titre de variante, le substrat semiconducteur est de type SOI (de l'anglais "Semiconductor On Insulator" - semiconducteur sur isolant) et comprend par exemple un support en silicium revêtu d'une couche isolante elle-même revêtue d'une couche en silicium monocristallin.

Dans l'exemple représenté, le circuit de contrôle 151 comprend, du côté de sa face supérieure, pour chacune des LED inorganiques L du dispositif, un plot métallique de connexion 153 destiné à être connecté à l'une des électrodes (anode ou cathode) de la LED, de façon à pouvoir commander un courant circulant dans la LED et/ou appliquer une tension aux bornes de la LED. Le circuit de contrôle 151 comprend par exemple, pour chaque LED connectée au plot métallique 153 dédié à la LED, une cellule élémentaire de contrôle comportant un ou plusieurs transistors, permettant de contrôler le courant circulant dans la LED et/ou la tension appliquée aux bornes de la LED. Bien que cela n'ait pas été détaillé, on peut prévoir, dans le cas où le dispositif comporte des LED de différents types, par exemple des LED rouges, vertes et bleues, que le circuit de contrôle 151 présente une architecture spécifique à chaque type de LED.

Dans cet exemple, le circuit de contrôle 151 comprend en outre, du côté de sa face supérieure, pour chacune des diodes photosensibles D du dispositif, un plot métallique 155 destiné à être connecté à l'une des électrodes (anode ou cathode) de la diode photosensible, de façon à pouvoir recevoir des charges photogénérées dans la diode photosensible. Le circuit de contrôle 151 comprend par exemple, pour chaque diode photosensible connectée au plot métallique 155 dédié à la diode photosensible, une cellule élémentaire de lecture comportant un ou plusieurs transistors, permettant par exemple de transférer les charges photogénérées dans la diode photosensible vers un nœud de lecture.

Dans l'exemple considéré où le dispositif comporte une unique diode photosensible et une unique LED inorganique par pixel, le circuit de contrôle 151 comprend autant de plots 153 que de plots 155. Les plots 153 et 155 forment par exemple un motif se répétant de façon régulière le long de lignes et de colonnes à la surface du circuit de contrôle 151.

Le circuit de contrôle 151 est par exemple réalisé en technologie CMOS (de l'anglais "Complementary Metal-Oxide-Semiconductor" - métal oxyde semiconducteur complémentaire). Les plots métalliques 153 et 155 peuvent être latéralement entourés par un matériau isolant 157, par exemple du dioxyde de silicium, de façon que le circuit de contrôle 151 présente une surface supérieure sensiblement plane comprenant une alternance (ou damier) de régions métalliques 153, 155 et de régions isolantes 157. Les plots métalliques 153 et 155 et le matériau isolant 157 forment par exemple, sur le circuit de contrôle 151, un niveau présentant des caractéristiques, par exemple de dimensions et/ou de répartition des plots 153 et 155, d'état de surface, etc. adaptées à la réalisation ultérieure d'un collage hybride. On peut en outre prévoir un niveau intermédiaire comprenant un ou plusieurs vias assurant une fonction d'interconnexion entre le circuit de contrôle CMOS 151 et le niveau comprenant les plots 153 et 155 et le matériau isolant 157. Le contact sur les électrodes des LED inorganiques L et des diodes photosensibles D (cathodes ou anodes) non connectées aux plots 153, 155 peut être pris de façon collective, par exemple dans une région périphérique du circuit de contrôle 151, par l'intermédiaire d'un ou plusieurs plots de connexion (non visibles sur les figures) du circuit de contrôle 151.

La figure 1F est une vue en coupe illustrant une structure obtenue à l'issue d'une étape ultérieure de report de la structure de la figure 1D sur la face supérieure du circuit de contrôle 151. Pour cela, l'ensemble comportant le substrat de support 105, les cellules d'émission 101, les couches électriquement isolantes 107 et 111, les électrodes 109 et les plots métalliques 113 peut être retourné, puis rapporté sur le circuit de contrôle 151, de façon à mettre en contact la face inférieure (dans l'orientation de la figure 1F) de la couche isolante 111 avec les faces supérieures des régions isolantes 157 et des plots 155, et la face inférieure des plots 113 avec la face supérieure des plots 153. Au cours de cette étape, les LED inorganiques L sont fixées (bonded) au circuit de contrôle 151. À titre d'exemple, la fixation des LED sur le circuit de contrôle 151 peut être obtenue par collage direct hybride ("Direct Hybrid Bonding", en anglais) entre les deux surfaces mises en contact. À titre de variante, la fixation des deux surfaces peut être réalisée par thermocompression, collage eutectique, ou par toute autre méthode de fixation adaptée. À l'issue de cette étape, chaque LED a son électrode d'anode 109 connectée au plot métallique 153 sous-jacent par l'intermédiaire du plot métallique 113. Ceci permet un contrôle individuel des LED par le circuit de contrôle 151.

En outre, au cours de cette étape, le substrat de support 105 des LED inorganiques L est retiré de façon à découvrir la face supérieure (dans l'orientation de la figure 1F) de la couche électriquement isolante 107. Le substrat 105 est par exemple retiré par meulage et/ou gravure à partir de sa face opposée aux cellules d'émission 101. À titre de variante, dans le cas d'un substrat 105 transparent, par exemple un substrat en saphir ou en corindon, le substrat 105 peut être détaché de la couche 107 au moyen d'un faisceau laser projeté à travers le substrat 105 depuis sa face opposée à la couche 107 (procédé de type "laser lift-off"). Plus généralement, toute autre méthode permettant de retirer le substrat 105 peut être utilisée. Après le retrait du substrat 105, une étape supplémentaire de gravure peut être prévue pour retirer d'éventuelles couches tampon subsistant du côté de la face supérieure de la couche isolante 107.

La figure 1G est une vue en coupe illustrant une structure obtenue à l'issue d'une étape ultérieure de formation, dans les couches électriquement isolantes 107 et 111, d'ouvertures ou tranchées traversantes 159, en regard des plots métalliques de connexion 155, de sorte à découvrir au moins partiellement la face supérieure des plots métalliques de connexion 155. Les tranchées 159 sont par exemple formées à l'aplomb de zones situées entre les LED inorganiques L où l'on souhaite réaliser ultérieurement les diodes photosensibles D du dispositif. À titre d'exemple, les tranchées 159 sont formées par photolithographie puis gravure, par exemple par gravure plasma, des couches isolantes 107 et 111.

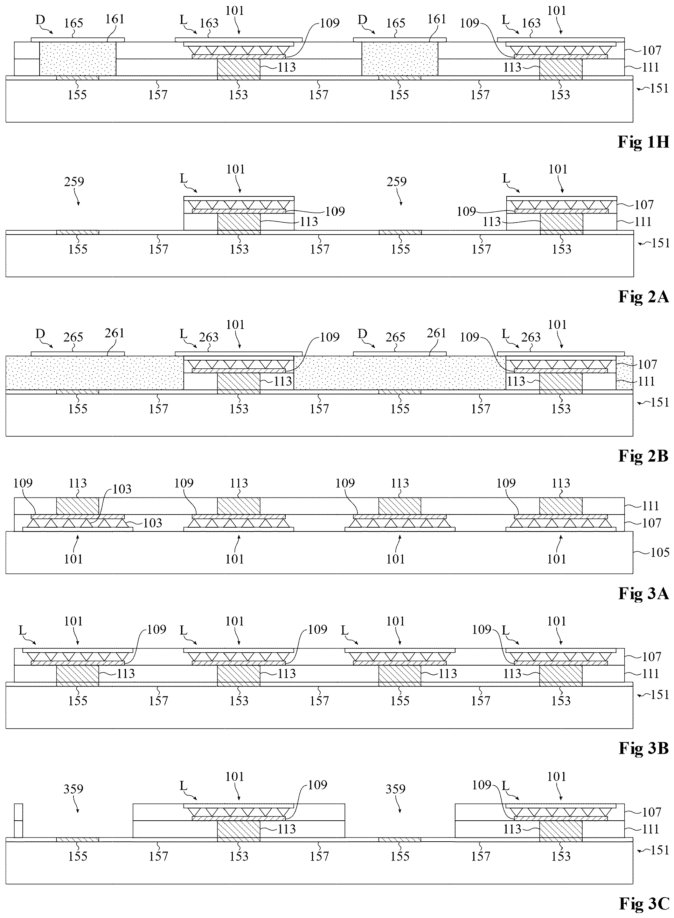

La figure 1H est une vue en coupe illustrant une structure obtenue à l'issue d'une étape ultérieure de dépôt d'une couche active semiconductrice 161 sur les parois latérales et sur le fond des tranchées 159. Dans l'exemple représenté, la couche 161 comble entièrement les tranchées 159, de sorte que la couche 161 affleure la face supérieure de la couche 107. En d'autres termes, la couche 161 remplit totalement les espaces laissés libres entre les LED inorganiques. À titre de variante, la couche 161 peut présenter une hauteur inférieure à celle de l'empilement formé par les couches 107 et 111, par exemple comprise entre 0,5 et 1 µm.

La couche active 161 est par exemple une couche organique comportant un ou plusieurs matériaux polymères semiconducteurs, une couche comportant des boîtes quantiques ("quantum dots" - QDs, en anglais), ou une couche comportant des boîtes quantiques dans une matrice polymère, ou encore tout type de couche organique remplissant une fonction de capture de photons. Selon le matériau considéré, le dépôt de la couche active 161 peut être réalisé par exemple par voie liquide. Plus précisément, la couche active 161 peut par exemple être obtenue par une technique de dépôt à la tournette ("spin-coating", en anglais), de revêtement par filière ("slot-die coating", en anglais), ou de revêtement à la lame ("blade-coating", en anglais) d'une solution de polymère et/ou de boîtes quantiques, par exemple une solution colloïdale de nanocristaux semiconducteurs. En pratique, un empilement d'une ou plusieurs couches, choisies par exemple parmi des couches d'injection et/ou de transport de trous ou des couches de blocage d'électrons (non représentées), peut être déposé sur le fond des tranchées 159 préalablement au dépôt de la couche active 161.

Le remplissage des tranchées 159 par la couche active 161 conduit à former une pluralité de diodes photosensibles D, ou photodétecteurs. Chaque diode photosensible D comprend un empilement vertical comportant, dans l'ordre à partir de la surface supérieure du circuit de contrôle 151, l'un des plots de connexion 155, correspondant à l'électrode d'anode de la diode photosensible, et une portion de la couche active 161 située sensiblement à l'aplomb du plot 155. De façon avantageuse, la couche active 161 présente par exemple des propriétés de conduction électrique anisotropes. Plus précisément, la couche active 161 présente par exemple une faible conduction électrique latérale, permettant d'isoler électriquement chaque diode photosensible 161 par rapport aux diodes photosensibles voisines, et une conduction électrique verticale forte, par exemple supérieure à la conduction électrique latérale, de sorte à faciliter le transport vertical des porteurs photogénérés dans la couche active 161 vers les électrodes de la diode photosensible D. En pratique, un empilement d'une ou plusieurs couches, choisies par exemple parmi des couches d'injection et/ou de transport d'électrons ou des couches de blocage de trous (non représentées), peut ultérieurement être déposé sur la couche active 161.

En outre, au cours de cette étape, des électrodes de cathode sont réalisées sur les empilements des LED inorganiques L et des diodes photosensibles D du dispositif. On forme par exemple plus précisément des électrodes de cathode 163 communes à toutes les LED d'une même rangée de LED du dispositif et des électrodes de cathode 165 communes à toutes les diodes photosensibles d'une même rangée de diodes photosensibles du dispositif. Les électrodes de cathode 163 et 165 sont par exemple en un oxyde conducteur transparent, par exemple l'ITO (de l'anglais "Indium Tin Oxide", oxyde d'indium-étain). Le matériau des électrodes de cathode 163 et 165 est par exemple déposé sur toute la surface de l'empilement, par exemple par dépôt physique en phase vapeur ("Physical Vapor Deposition" - PVD, en anglais), puis recuit à une température d'environ 100 °C. Le matériau est ensuite gravé, par exemple par gravure plasma à faible énergie ou par gravure humide, par exemple à base d'acide chlorhydrique, de sorte à former les électrodes de cathode communes 163 et 165. À titre de variante, dans un cas où les LED et les diodes photosensibles du dispositif présentent des tensions de polarisation semblables, une unique électrode de cathode commune à toutes les LED et à toutes les diodes photosensibles du dispositif peut être prévue, le contrôle individuel des LED et des diodes photosensibles s'effectuant par les plots conducteurs 153 et 155, respectivement.

Bien que cela n'ait pas été représenté, on peut prévoir de connecter les électrodes 163 et 165 à des éléments de reprise de contact du circuit de contrôle 151, par exemple par l'intermédiaire de vias métalliques formés préalablement au dépôt des électrodes 163 et 165. Cela permet de réduire des chutes de tension liées à des résistances série. À titre de variante, des pistes métalliques peuvent être formées sur et en contact avec les électrodes 163 et 165, l'alimentation des LED et des diodes photosensibles s'effectuant alors par interconnexion tridimensionnelle. On peut en outre prévoir des tensions de polarisation différentes pour chaque type de LED.

Dans l'exemple représenté, un dispositif combinant des fonctions d'émission lumineuse et de photodétection est obtenu à l'issue des étapes décrites en relation avec les figures 1A à 1H.

À titre de variante, les étapes précédemment décrites en relation avec les figures 1C et 1D sont par exemple remplacées par des étapes de réalisation d'une structure analogue à celle de la figure 1D, mais dépourvue du substrat 105 et comprenant un substrat de support temporaire du côté de la face supérieure de la couche 111 et des éléments de reprise de contact situés du côté de la face inférieure des cellules d'émission 101. À l'étape de la figure 1F les éléments de reprise de contact situés du côté de la face inférieure des cellules d'émission sont mis en contact avec les plots 155 du circuit intégré 151, puis le substrat de support temporaire situé du côté de la face supérieure de la couche 111 est retiré.

Les figures 2A et 2B sont des vues en coupe illustrant des étapes successives d'une variante du procédé des figures 1A à 1H. Les premières étapes de cette variante sont par exemple identiques aux étapes décrites ci-dessus en relation avec les figures 1A à 1F.

La figure 2A est une vue en coupe illustrant une structure obtenue, partant de la structure précédemment décrite en relation avec la figure 1F, à l'issue d'une étape ultérieure de formation, dans les couches électriquement isolantes 107 et 111, d'ouvertures ou tranchées traversantes 259, en regard des plots métalliques de connexion 155, de sorte à découvrir au moins partiellement (totalement, dans l'exemple représenté) la face supérieure des plots métalliques de connexion 155. Les tranchées 259 sont par exemple formées à l'aplomb de zones situées entre les LED inorganiques L où l'on souhaite réaliser ultérieurement les diodes photosensibles D du dispositif. Les tranchées 259 présentent plus particulièrement des parois latérales qui affleurent les cellules d'émission 101.

À la différence des tranchées 159 de la figure 1G, formées par exemple par des étapes de photolithographie mettant en œuvre une couche de résine photosensible déposée du côté de la face supérieure de la couche 107 puis de gravure des couches isolantes 107 et 111, les tranchées 259 sont gravées en utilisant les cellules d'émission 101 comme masque de gravure. Cela permet par exemple avantageusement d'éviter des étapes de dépôt, d'insolation et d'élimination d'une couche de résine photosensible, ainsi que des étapes d'alignement d'un masque d'insolation de la couche de résine. On obtient ainsi une structure dite auto-alignée, ce qui présente comme avantage de maximiser la surface active des LED inorganiques L et des diodes photosensibles D du dispositif. Une couche de germination ou une couche d'arrêt de gravure peut être prévue sous les éléments semiconducteurs tridimensionnels 103 de sorte à permettre d'éliminer de façon sélective des parties de la couche 107 situées entre les cellules d'émission 101 que l'on souhaite conserver.

La figure 2B est une vue en coupe illustrant une structure obtenue à l'issue d'une étape ultérieure de dépôt d'une couche active semiconductrice 261 sur les parois latérales et sur le fond des tranchées 259. En outre, au cours de cette étape, des électrodes de cathode 263 et 265 sont réalisées sur les empilements des LED inorganiques L et des diodes photosensibles D du dispositif.

À titre d'exemple, la composition et les procédés mis en œuvre pour réaliser la couche active semiconductrice 261 et les électrodes 263 et 265 sont par exemple analogues à ce qui a été décrit ci-dessus en relation avec la figure 1H pour la couche active semiconductrice 161 et les électrodes 163 et 165, respectivement.

À l'issue de l'étape de la figure 2B, on obtient un dispositif électronique combinant des fonctions d'émission lumineuse et de photodétection analogues à celles du dispositif de la figure 1H. Un avantage du procédé décrit en relation avec les figures 2A et 2B tient au fait qu'il permet d'obtenir des diodes photosensibles D présentant une surface active encore plus grande que dans le cas du dispositif obtenu par la mise en œuvre du procédé des figures 1A à 1H.

Les figures 3A à 3C sont des vues en coupe illustrant des étapes successives d'une autre variante du procédé des figures 1A à 1H. Les premières étapes de cette variante diffèrent des étapes précédemment décrites en relation avec les figures 1A à 1D notamment en ce que les cellules d'émission 101 sont conservées aux emplacements souhaités des diodes photosensibles D.

La figure 3A est une vue en coupe illustrant une structure obtenue par exemple en omettant l'étape de la figure 1B et en réalisant des étapes analogues à celles précédemment décrites en relation avec les figures 1C et 1D à partir de la structure illustrée en figure 1A. Dans l'exemple représenté, des cellules d'émission 101 surmontées chacune d'une électrode 109 et d'un plot conducteur 113 sont formées non seulement aux emplacements souhaités des LED inorganiques L, mais également aux emplacements souhaités des diodes photosensibles D. À titre de variante, on pourrait prévoir de réaliser les plots 113 uniquement aux emplacements souhaités des LED inorganiques L.

La figure 3B est une vue en coupe illustrant une structure obtenue à l'issue d'une étape ultérieure de report de la structure de la figure 3A sur la face supérieure du circuit de contrôle 151 précédemment décrit en relation avec la figure 1E. Au cours de cette étape, analogue à celle précédemment décrite en relation avec la figure 1F, l'ensemble comportant le substrat de support 105, les cellules d'émission 101, les couches électriquement isolantes 107 et 111, les électrodes 109 et les plots métalliques 113 peut être retourné, puis rapporté sur le circuit de contrôle 151, de façon à mettre en contact la face inférieure (dans l'orientation de la figure 3B) de la couche isolante 111 avec les faces supérieures des régions isolantes 157, et la face inférieure des plots 113 avec la face supérieure des plots 153 et 155. Au cours de cette étape, les LED inorganiques L sont fixées (bonded) au circuit de contrôle 151.

En outre, au cours de cette étape, le substrat de support 105 des LED inorganiques L est retiré de façon à découvrir la face supérieure (dans l'orientation de la figure 3B) de la couche électriquement isolante 107.

À titre d'exemple, les procédés mis en œuvre pour le report sur le circuit de contrôle 151 et le retrait du substrat de support 105 sont par exemple analogues aux procédés décrits ci-dessus en relation avec la figure 1F.

La figure 3C est une vue en coupe illustrant une structure obtenue à l'issue d'une étape ultérieure de formation d'ouvertures ou tranchées traversantes 359, en regard des plots métalliques de connexion 155, de sorte à découvrir au moins partiellement la face supérieure des plots métalliques de connexion 155. Les tranchées 359 sont par exemple formées en éliminant les LED inorganiques L situées aux emplacements où l'on souhaite réaliser ultérieurement les diodes photosensibles D du dispositif. Les LED inorganiques L connectées aux plots 153 sont toutefois conservées. À titre d'exemple, les tranchées 359 sont formées par photolithographie puis gravure, par exemple par gravure plasma ou par une combinaison de gravures sèches et humides, par exemple dans un cas où les plots 113 sont en cuivre, des cellules d'émission 101, des électrodes 109 et des plots conducteurs 113 des LED inorganiques L que l'on souhaite retirer.

Partant de la structure illustrée en figure 3C, des étapes ultérieures analogues à celles précédemment décrites en relation avec les figures 1G et 1H peuvent être réalisées de sorte à obtenir un dispositif optoélectronique combinant des fonctions d'émission lumineuse et de photodétection analogues à celles des dispositifs des figures 1H et 2B.

Le procédé décrit en relation avec les figures 1A à 1H et les variantes décrites en relation avec les figures 2A et 2B et 3A à 3C peuvent être utilisés pour réaliser des micro-écrans monolithiques, combinant une fonction d'affichage d'images et une fonction de capture optique, par exemple pour réaliser un écran interactif adapté à mettre en œuvre des fonctions de reconnaissance faciale ou du regard ("eye tracking", en anglais), de reconnaissance de formes, de détection de mouvement, d'identification, etc. Un avantage des procédés décrits est qu'ils permettent de réaliser des pixels d'affichage et des pixels de capture de petites dimensions latérales, et ainsi obtenir des résolutions d'affichage et des résolutions de capture élevées. On notera que dans l'exemple décrit ci-dessus, le dispositif comprend des macro-pixels comprenant chacun un pixel de détection et un pixel d'émission adapté à émettre dans une seule gamme de longueurs d'ondes. Toutefois, le procédé et les variantes décrits ci-dessus peuvent être adaptés pour réaliser par exemple des macro-pixels comprenant chacun un pixel de détection et trois pixels d'émission adaptés à émettre respectivement dans trois gammes de longueurs d'ondes distinctes, c'est-à-dire un dispositif présentant, en émission et en réception, des résolutions identiques. À titre d'exemple, les trois gammes de longueurs d'ondes distinctes peuvent être obtenues par émission directe et/ou par conversion, par exemple par des structures de type puits quantiques ou nanophosphores. À titre de variante, la résolution du dispositif d'affichage et la résolution du capteur optique peuvent être différentes. En particulier, le nombre de pixels de détection peut être inférieur au nombre de pixels d'émission d'une même gamme de longueurs d'ondes. On pourrait en outre prévoir un dispositif comprenant trois pixels d'émission adaptés à émettre dans le visible et au moins un autre pixel d'émission adapté à émettre dans l'infrarouge, par exemple un pixel comprenant une région active à base d'au moins un matériau de type pérovskite, par exemple pour réaliser de l'imagerie active. Dans ce cas, on pourrait plus particulièrement prévoir l'ajout de filtres de couleur surmontant au moins une partie des cellules d'émission 101 des LED inorganiques L et/ou la réalisation de cellules d'émission 101 émettant dans des plages de longueurs d'ondes distinctes.

À titre de variante, le procédé décrit en relation avec les figures 1A à 1H et les variantes décrites en relation avec les figures 2A et 2B et 3A à 3C peuvent être utilisés pour réaliser des dispositifs d'affichage interactifs de plus grandes dimensions, par exemple un écran de télévision, d'ordinateur, de smartphone, de tablette numérique, etc. Un tel dispositif peut comporter une pluralité de puces électroniques élémentaires disposées, par exemple selon un agencement matriciel, sur un même substrat de report. Les puces élémentaires sont montées solidaires du substrat de report et connectées à des éléments de connexion électrique du substrat de report pour leur commande. Chaque puce comporte une ou plusieurs LED, une ou plusieurs diodes photosensibles, et un circuit 151 de commande de ladite une ou plusieurs LED et de ladite une ou plusieurs diodes photosensibles. Chaque puce correspond par exemple à un macro-pixel du dispositif. À titre d'exemple, chaque puce comprend trois LED commandables individuellement, définissant respectivement trois pixels d'émission adaptés à émettre respectivement de la lumière rouge, de la lumière verte et de la lumière bleue, et une diode photosensible adaptée à détecter un rayonnement infrarouge ou proche infrarouge, définissant un pixel de détection.

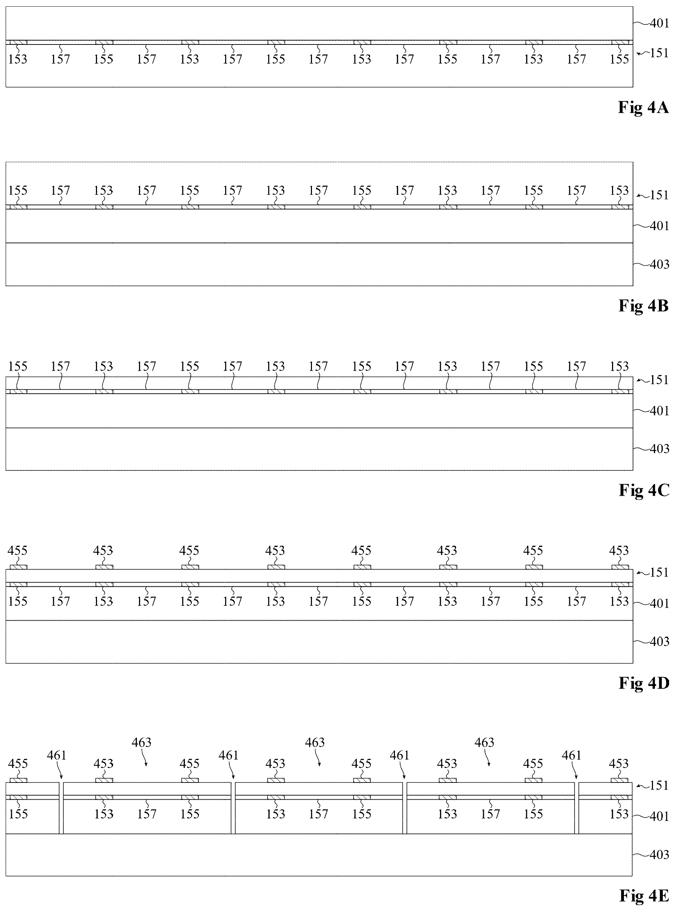

Les figures 4A à 4G sont des vues en coupe illustrant des étapes successives d'un exemple d'un procédé de fabrication d'un tel dispositif.

La figure 4A est une vue en coupe illustrant de façon très schématique une structure de départ correspondant à une structure du type de celle obtenue par le procédé des figures 1A à 1H, par la variante des figures 2A et 2B, ou par la variante des figures 3A à 3C, comprenant un étage de circuit intégré de contrôle 151 surmonté d'un étage 401 de photodétection et d'émission. L'étage 401 de photodétection et d'émission comprend une pluralité de diodes photosensibles (non détaillées sur les figures 4A à 4G) commandables individuellement par le circuit 151 et une pluralité de LED inorganiques (non détaillées sur les figures 4A à 4G) commandables individuellement par le circuit 151. Afin de ne pas surcharger le dessin, seuls les plots 153 et 155 du circuit intégré 151, situés du côté de la face supérieure du circuit intégré 151, ont été détaillés sur la figure 4A.

La figure 4B illustre une étape de collage de la structure de la figure 4A sur un substrat de support temporaire 403, par exemple en silicium. La structure de la figure 4A est fixée au substrat de support 403 par sa face opposée au circuit intégré de contrôle 151, c'est-à-dire par sa face inférieure dans l'orientation de la figure 4B, correspondant à sa face supérieure dans l'orientation de la figure 4A.

La figure 4C illustre une étape optionnelle d'amincissement du substrat semiconducteur du circuit intégré 151, par sa face opposée à l'étage 401. À titre d'exemple, le circuit intégré 151 est initialement formé dans et sur un substrat de type SOI (de l'anglais "Semiconductor On Insulator" - semiconducteur sur isolant). Le substrat SOI comprend par exemple un support en silicium, revêtu d'une couche isolante, elle-même revêtue d'une couche de silicium monocristallin (non détaillés sur les figures). Les composants, notamment des transistors, du circuit intégré 151, peuvent être formés dans et sur la couche de silicium monocristallin du substrat SOI. L'étape d'amincissement de la figure 4C peut consister à retirer le substrat de support du substrat SOI, de façon à ne conserver que la couche de silicium monocristallin et la couche isolante du substrat SOI.

À titre de variante, le circuit intégré 151 est formé dans et sur un substrat massif de silicium, l'étape d'amincissement pouvant alors consister à réduire l'épaisseur du substrat, par exemple par meulage, à partir de sa face supérieure (dans l'orientation de la figure 4C). Une couche isolante de passivation (non détaillée sur la figure) peut ensuite être déposée sur la face supérieure du substrat aminci.

La figure 4D illustre une étape de formation, du côté de la face supérieure du circuit intégré 151, de plots métalliques de connexion 453 et 455, respectivement reliés aux plots de connexion 153 et 155 et/ou à des bornes de connexion de composants électroniques, par exemple des transistors MOS, du circuit intégré 151, par l'intermédiaire de vias conducteurs non détaillés sur la figure, traversant le substrat semiconducteur du circuit intégré 151. Les plots 453, 455 étant pour l'essentiel reliés à des bornes de connexion à l'intérieur du circuit, leur nombre est en pratique supérieur au nombre de plots 153, 155. À titre d'exemple, on forme ainsi un circuit d'adressage du type de celui décrit dans la demande FR 1561421.

La figure 4E illustre une étape de formation, à partir de la face supérieure du circuit intégré 151, de tranchées 461 traversant verticalement le circuit intégré 151 et l'étage 401 de photodétection et d'émission et débouchant sur la face supérieure du substrat de support temporaire 403. Les tranchées 461 délimitent latéralement une pluralité de puces semiconductrices 463 correspondant aux puces élémentaires de pixel du dispositif d'affichage. Les tranchées 461 peuvent être formées par gravure plasma, par sciage, ou par toute autre méthode de découpe adaptée. Dans l'exemple représenté, les portions de l'étage 401 et du circuit intégré 151 présentent, après découpe, des flancs alignés verticalement les uns par rapport aux autres.

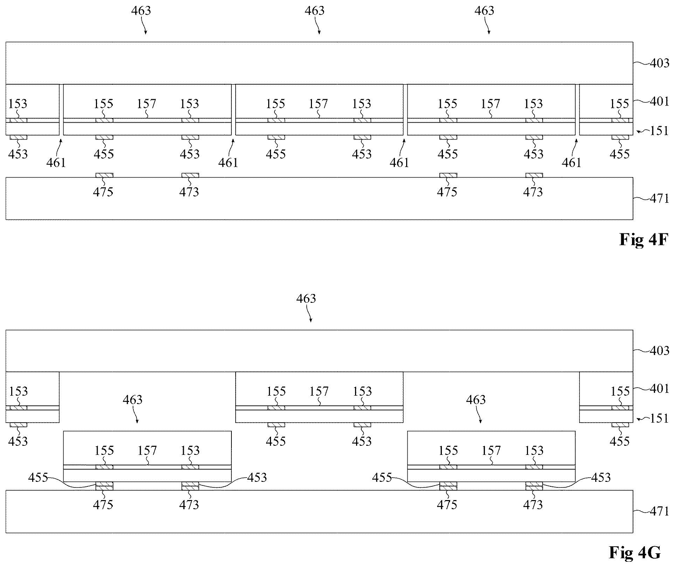

Les figures 4F et 4G illustrent une étape de fixation de puces élémentaires 463 sur la face supérieure d'un même substrat de report 471 du dispositif d'affichage. Le substrat de report 471 comprend, du côté de sa face supérieure, une pluralité de plots métalliques de connexion 473, destinés à être fixés et connectés électriquement et mécaniquement à des plots de connexion métalliques correspondants 453 des puces élémentaires 463, et une pluralité de plots métalliques de connexion 475, destinés à être fixés et connectés électriquement et mécaniquement à des plots de connexion métalliques correspondants 455 des puces élémentaires 463.

La structure de la figure 4E est retournée (figure 4F) de façon à placer les plots de connexion métalliques 453, 455 de puces élémentaires 463 en vis-à-vis de plots de connexion métalliques 473, 475 correspondants du substrat de report 471. Les plots 453 et 473 en vis-à-vis et les plots 455 et 475 en vis-à-vis sont ensuite fixés et connectés électriquement, par exemple par collage direct, par soudure, au moyen de microtubes, ou par toute autre méthode adaptée.

Une fois fixées au substrat de report 471, les puces élémentaires 463 sont détachées du substrat de support temporaire 403, et ce dernier est retiré (figure 4G). À titre d'exemple, le détachage des puces est réalisé par décollement mécanique ou par décollement au moyen d'un faisceau laser.

Le pas (distance centre à centre en vue de face) des puces élémentaires 463 sur le substrat de report 471 est par exemple un multiple du pas des puces élémentaires 463 sur le substrat 403. Ainsi, seule une partie des puces élémentaires 463 (une sur deux, dans l'exemple représenté) est transférée simultanément du substrat de support temporaire 403 sur le substrat de report 471. Les autres puces restent attachées au substrat de support temporaire 403 et peuvent être reportées ultérieurement sur une autre partie du substrat de report 471 ou sur un autre substrat de report.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les variantes décrites respectivement en relation avec les figures 2A et 2B et 3A à 3C peuvent être combinées. Plus précisément, l'étape décrite en relation avec la figure 2A peut être réalisée à partir de la structure obtenue à l'issue de l'étape décrite en relation avec la figure 3C. En outre, les modes de réalisation décrits ne se limitent pas aux exemples de matériaux et/ou de dimensions mentionnés dans la présente description.

Enfin, la mise en œuvre pratique des modes de réalisation et variantes décrits est à la portée de la personne du métier à partir des indications fonctionnelles données ci-dessus.

## Revendications

1. Procédé de fabrication d'un dispositif optoélectronique comprenant les étapes successives suivantes :
a) former, sur un circuit intégré de contrôle (151) préalablement formé dans et sur un substrat semiconducteur, une pluralité de diodes électroluminescentes inorganiques (L) comportant des éléments semiconducteurs tridimensionnels (103) ; et
b) déposer une couche active semiconductrice photosensible (161 ; 261) de sorte à remplir totalement tous les espaces libres s'étendant latéralement entre les diodes électroluminescentes inorganiques (L).

2. Procédé selon la revendication 1, dans lequel chaque élément semiconducteur tridimensionnel (103) présente des dimensions nanométriques ou micrométriques.

3. Procédé selon la revendication 1 ou 2, dans lequel chaque élément semiconducteur tridimensionnel (103) présente une forme pyramidale.

4. Procédé selon la revendication 1 ou 2, dans lequel chaque élément semiconducteur tridimensionnel (103) présente une forme filaire.

5. Procédé selon l'une quelconque des revendications 1 à 4, comprenant la formation d'une pluralité de diodes photosensibles (D) dans la couche active semiconductrice photosensible (161 ; 261).

6. Procédé selon la revendication 5, comprenant, avant l'étape a), une étape d'élimination des diodes électroluminescentes inorganiques (L) situées à des emplacements souhaités des diodes photosensibles (D).

7. Procédé selon l'une quelconque des revendications 1 à 6, comprenant, après l'étape a) et avant l'étape b), une étape de formation d'ouvertures (159 ; 259 ; 359) s'étendant latéralement entre les diodes électroluminescentes inorganiques (L).

8. Procédé selon la revendication 7, dans lequel les ouvertures (259) sont formées par gravure en utilisant les diodes électroluminescentes inorganiques (L) comme masque de gravure.

9. Procédé selon l'une quelconque des revendications 1 à 8, dans lequel la couche active semiconductrice photosensible (161 ; 261) comprend au moins un matériau polymère.

10. Procédé selon l'une quelconque des revendications 1 à 9, dans lequel la couche active semiconductrice photosensible (161 ; 261) comprend des boîtes quantiques.

11. Procédé selon l'une quelconque des revendications 1 à 10, dans lequel la couche active semiconductrice photosensible (161 ; 261) est une couche semiconductrice organique.

12. Procédé selon l'une quelconque des revendications 1 à 11, dans lequel la couche active semiconductrice photosensible (161 ; 261) est déposée par voie liquide entre les diodes électroluminescentes inorganiques (L).

13. Procédé selon l'une quelconque des revendications 1 à 12, comportant, après l'étape b), une étape de fixation d'un substrat de support temporaire (403) du côté d'une face du dispositif opposée au circuit intégré (151), suivie d'une étape de découpe de l'ensemble comportant le circuit intégré (151), la couche active semiconductrice photosensible (161 ; 261) et les diodes électroluminescentes inorganiques (L) en une pluralité de puces élémentaires (463).

14. Procédé selon la revendication 13, comportant en outre une étape de transfert et de fixation desdites puces élémentaires (463) sur un substrat de report (471) du dispositif, puis une étape de retrait du substrat de support temporaire (403).

15. Dispositif optoélectronique comportant :
- un circuit intégré de contrôle (151) formé dans et sur un substrat semiconducteur ;
- une pluralité de diodes électroluminescentes inorganiques (L) disposées sur une face du circuit intégré de contrôle (151) et comportant des éléments semiconducteurs tridimensionnels (103) ; et
- une couche active semiconductrice photosensible (161 ; 261) remplissant totalement tous les espaces libres s'étendant latéralement entre les diodes électroluminescentes inorganiques (L).

16. Dispositif optoélectronique comportant un substrat de report (403) et une pluralité de puces élémentaires (463) fixées et connectées électriquement au substrat de report (403), chaque puce élémentaire (463) comprenant un dispositif selon la revendication 15, le circuit intégré de contrôle (151) étant disposé du côté du substrat de report (403).
